# EUROPÄISCHE PATENTSCHRIFT

(11) **EP 2 394 499 B1**
(45) Veröffentlichungstag und Bekanntmachung des Hinweises auf die Patenterteilung: **29.05.2013**
(21) Anmeldenummer: 10701682.6
(22) Anmeldetag: 29.01.2010
(51) Int. Cl.: H05K 1/02, H05K 1/03, G02B 6/42

(54) **ELEKTROOPTISCHES STEUER- ODER REGELGERÄT ZUM AUSTAUSCH VON STEUER- ODER REGELSIGNALEN**
ELECTRO-OPTICAL CONTROL OR REGULATION DEVICE FOR EXCHANGING CONTROL OR REGULATION SIGNALS
APPAREIL DE COMMANDE OU DE RÉGLAGE OPTO-ÉLECTRONIQUE D'ÉCHANGE DE SIGNAUX DE COMMANDE ET DE RÉGLAGE

(30) Priorität: 09.02.2009 DE 102009008087
(43) Veröffentlichungstag der Anmeldung: 14.12.2011
(73) Patentinhaber: Continental Automotive GmbH, 30165 Hannover (DE)
(72) Erfinder: BAUR, Frank, 90482 Nürnberg (DE); DEML, Ulrich, 93138 Lappersdorf (DE); GÖTTE, Carsten, 93080 Pentling / Großberg (DE)
(86) Internationale Anmeldenummer: PCT/EP2010/051068
(87) Internationale Veröffentlichungsnummer: WO 2010/089254

(56) Entgegenhaltungen:
- EP-A1- 1 650 253
- EP-A2- 0 986 197
- WO-A1-2005/078497
- WO-A1-2007/114384
- DE-A1- 2 343 235
- DE-A1- 19 643 911
- GB-A- 1 385 526
- US-A1- 2005 063 637
- US-A1- 2006 093 259
- US-A1- 2007 154 132
- US-A1- 2008 008 477

## Beschreibung

Die Erfindung betrifft ein elektrooptisches Steuer- oder Regelgerät. Dazu weist das Steuer- oder Regelgerät eine zentrale Steuereinheit auf, die auf mindestens einer Schaltungsplatine mit einer Glasfaserverstärkung angeordnet ist.

Eine gedruckte Schalterkarte und eine Herstellung derselben ist aus der Druckschrift DE 10 2004 014 221 A1 bekannt, wobei die Schalterkarte oder Schaltungsplatine Kupferplattierungen auf beiden Seiten eines halbgehärteten Prepregs aufweist. Dabei sind in der gedruckten Schaltungsplatine optische Fasern enthalten, die mit regelmäßigen Zwischenräumen durch Fixierwerkzeuge in der gedruckten Schalterkarte angeordnet und in einem Epoxidharz eingebettet sind. Die mit regelmäßigen Zwischenräumen eingebetteten optischen Fasern dienen der Übertragung eines optischen Signals, wobei die Kupferplattierungen strukturiert sein können.

Eine derartige Schaltkarte hat den Nachteil, dass ein erheblicher Aufwand erforderlich ist, um in die Schaltungsplatine optische Übertragungsmittel in festgelegten Abständen und Längen einzubauen. Dieses ist kostenintensiv und schränkt die Möglichkeiten der optischen Übertragung auf die in die Schaltungsplatinen eingebrachten Lichtleitfasern ein.

Die US 2007/0154132 A1 lehrt den Fachmann ein elektrooptisches Steuer- oder Regelgerät und ein Verfahren zum Austausch von Steuer- oder Regelsignalen. Das Steuer- oder Regelgerät weist eine zentrale Steuereinheit auf, die auf mindestens einer Schaltungsplatine mit einer Glasfaserverstärkung angeordnet ist. Daten der Steuereinheit werden optisch an eine Strahlungsquelle und über ein optisches Übertragungsmittel zu einem Detektor übertragen, wobei als optisches Übertragungsmittel die Glasfaserverstärkung vorgesehen ist.

Durch dieses elektrooptische Steuer- oder Regelgerät können neue zusätzliche Übertragungswege in einer Leiterplatte, die unterhalb der Bestückungsseite einer Leiterplatine durch die Glasfaserverstärkung in faserverstärkten Schaltungsplatinen vorhanden sind, zusätzlich zu den metallischen Strukturen genutzt werden. Diese Übermittlungswege können ohne zusätzlichen Kostenaufwand betrieben werden, während oberhalb dieser Übermittlungswege eine Mehrzahlzahl von Bauelementen zusätzlich zu der Steuereinheit des elektrooptischen Steuer- oder Regelgerätes positioniert sein können.

Dieses Übertragungsprinzip ist auch für mehrschichtige Leiterplatten mit einer Mehrzahl von strukturierten Metallschichten innerhalb der Leiterplatte anwendbar, solange Glasfasergewebestrukturen zur Verstärkung in der mehrschichtigen Leiterplatte vorgesehen sind. Diese Glasfasern werden dann nicht nur zur Verstärkung, sondern auch zur optischen Übertragung von Signalen genutzt. Diese optischen Übertragungswege durch die Schaltungsplatine haben den Vorteil, dass störungssichere Übertragungskanäle für hohe Übertragungsraten im Vergleich zu Leiterbahnstrukturen einer strukturierten Kupferkaschierung geschaffen werden können, und somit eine störungssichere Übertragungslösung für sensible Datenmengen zur Verfügung steht.

Bei einer Leiterplatte mit optischer Lage gemäß der US 2005/0063637 A1, der WO 2005/078497 A1 oder der WO 2007/114384 A1 ist mindestens eine Glasfaserverstärkungslage in einer horizontalen Ebene parallel zu der Oberseite oder zu der Rückseite der Schaltungsplatine angeordnet und überträgt Signale zwischen der Strahlungsquelle und dem Detektor.

Die GB 1 385 526 offenbart eine Schaltungsplatine, bei der eine Glasfaserverstärkungslage ein Glasfasergewebe aufweist, in dem optische Signaldaten in alle horizontalen Richtungen übertragbar sind und die Gewebekreuzungen optische Koppelknoten bilden.

Die US 2006/0093259 A1 und die EP 0 986 197 A2 offenbaren optische Übertragungen in einer Leiterplatte bei denen eine optische Strahlungsquelle und ein optischer Detektors in entsprechenden Aussparungen der Platine derart angeordnet, dass ihre optischen Achsen in einer Ebene einer Glasfaserverstärkungslage angeordnet und aufeinander ausgerichtet sind sind.

Aufgabe der Erfindung ist es, in einer Schaltungsplatine zusätzliche Übertragungswege zu schaffen, welche die metallischen Schaltungsstrukturen einer gedruckten Leiterplatte ergänzen, ohne kostenintensive Einbauten in die Schaltungsplatine vornehmen zu müssen.

Diese Aufgabe wird mit dem Gegenstand des unabhängigen Anspruchs gelöst. Vorteilhafte Weiterbildungen der Erfindung ergeben sich aus dem abhängigen Anspruch.

In erfindungsgemäßer Weise weist ein elektrooptisches Steuer- oder Regelgerät eine Steuereinheit auf, die auf mindestens einer Schaltungsplatine, die eine obere Glasfaserverstärkungslage und eine tiefere Glasfaserverstärkungslage aufweist, angeordnet ist. Daten der Steuereinheit werden optisch von einer Strahlungsquelle über die obere Glasfaserverstärkungslage und die tiefere Glasfaserverstärkungslage als optischem Übertragungsmittel zu einem Detektor übertragen, wobei eine Aussparung in der Schaltungsplatine eine einseitige metallische Beschichtung aufweist, welche die über die obere Glasfaserverstärkungslage übertragene Strahlung der Strahlungsquelle reflektiert, und eine auf der Unterseite der Schaltungsplatine angeordnete Aussparung einen optischen Detektor aufweist, wobei der reflektierte Strahl in die tiefere Glasfaserverstärkungslage der Schaltungsplatine eingespeist wird und von dem Detektor empfangen wird.

Die Erfindung wird nun anhand der beigefügten Figuren näher erläutert.
- Figur 1: zeigt einen schematischen Querschnitt durch ein elektrooptisches Steuer- und/oder Regelgerät einer ersten Ausführungsform gemäß dem Stand der Technik;
- Figur 2: zeigt einen schematischen Querschnitt durch eine optische Übertragungsstrecke gemäß Figur 1;
- Figur 3: zeigt einen schematischen Querschnitt durch eine optische Übertragungsstrecke in einer Schaltungsplatine gemäß der Erfindung;

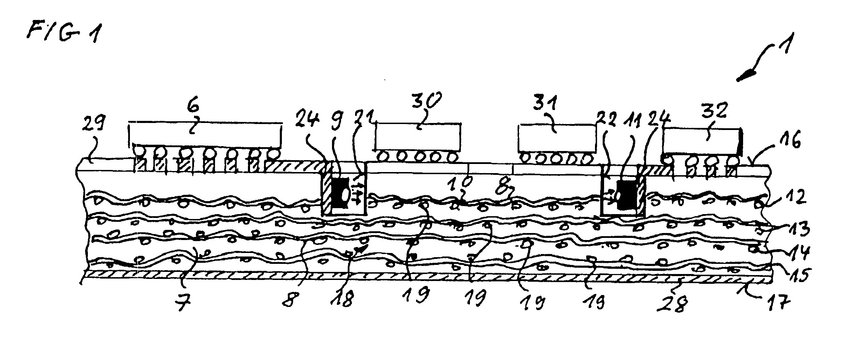

Figur 1 zeigt einen schematischen Querschnitt durch ein elektrooptisches Steuer- und/oder Regelungsgerät 1. Dazu weist das Steuer- und/oder Regelungsgerät 1 mindestens eine Steuereinheit 6 auf, die über eine metallische Schaltungsstruktur 29 auf der Oberseite 16 einer Schaltungsplatine 7 mit einer Strahlungsquelle 9 verbunden ist, wobei diese optischen Strahlungsquelle 9 in einer Aussparung 21 der Schaltungsplatine 7 angeordnet ist.

Die Schaltungsplatine 7 weist eine Mehrzahl von Glasfaserverstärkungslagen 12 bis 15 auf, die als Glasfasergewebe 18 ausgebildet sind, so dass sich Glasfasern in horizontaler Richtung sowohl entlang des hier gezeigten Querschnitts als auch orthogonal zu der Zeichenebene erstrecken. Dabei ergeben sich zusätzlich optische Koppelknoten 19 in dem Gewebe.

Die Aussparung 21 ist derart tief in die Leiterplatte 7 eingearbeitet, dass die Strahlungsquelle 9 über die Glasfaserverstärkungslage 12 eine optische Verbindung mit einem Detektor 11, der in einer weiteren Aussparung 22 angeordnet ist, bildet. Mit einer derartigen optischen Übertragungsstrecke 40 über das Übertragungsmittel 10 in Form einer Glasfaserverstärkung 8 der Schaltungsplatine 7 wird ein weiterer zusätzlicher Verbindungsweg zu den vorhandenen metallischen Verbindungen auf der Oberseite 16 der Schaltungsplatine 7 oder auf Zwischenmetalllagen einer mehrschichtigen Schaltungsplatine 7 geschaffen.

Ein weiterer Vorteil besteht darin, dass ohne zusätzlichen großen Aufwand nun die Glasfaserverstärkungslagen 12 bis 15 zur Signalübermittlung genutzt werden, während oberhalb der Glasfaserverstärkungslagen 12 bis 15 auf der Oberseite 16 der Schaltungsplatine 7 weitere Halbleiterbauelemente 30 und 31 über die Schaltungsstruktur 29 mit der Steuereinheit 6 zusammenwirken können. Auch der Detektor 11 in der Aussparung 22 kann über eine metallische Beschichtung 24 in der Aussparung 22, die mit der Schaltungsstruktur 29 in Verbindung steht, mit einem weiteren Halbleiterbauelement 32 über die Schaltungsstruktur 29 zusammenwirken. Somit eröffnet die erfindungsgemäße Nutzung des Glasfasergewebes 18 eine Verbesserung der Komplexität von elektrooptischen Steuer- oder Regelgeräten.

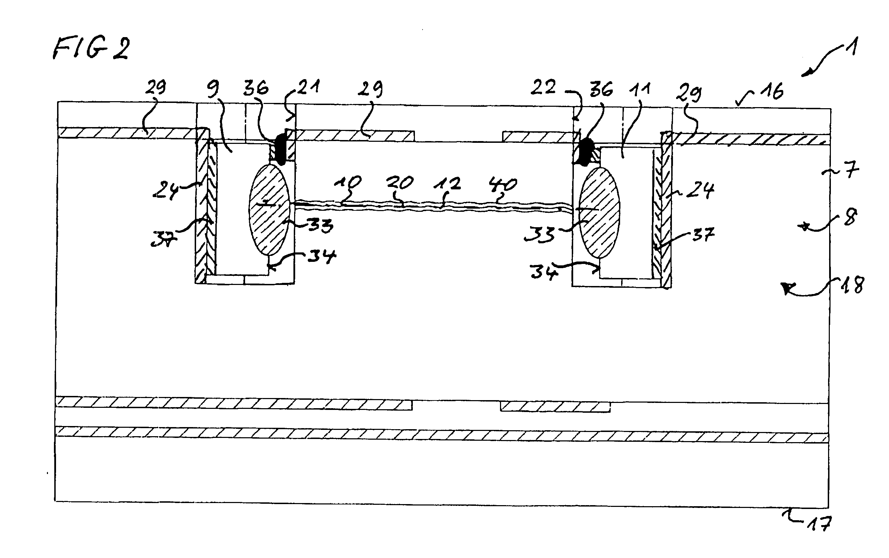

Figur 2 zeigt einen schematischen Querschnitt durch eine optische Übertragungsstrecke 40 gemäß Figur 1. Von den in Figur 1 gezeigten Glasfaserverstärkungslagen 12 bis 15 wird in Figur 2 lediglich die Verstärkungslage 12 zwischen der optischen Strahlungsquelle 9 und dem optischen Detektor 11 gezeigt. Dabei sind die optische Strahlungsquelle 9 und der optische Detektor 11 mit ihren optischen Achsen 20 aufeinander ausgerichtet, wobei die gemeinsame optische Achse 20 im Bereich der horizontalen Glasfaserlage 12 angeordnet ist.

Die Aussparungen 21 und 22 können durch einfache Einfräsungen in die Leiterplatte realisiert werden. Sowohl die optische Strahlungsquelle 9 als auch der optische Detektor 11 können mit einem Linsensystem 33 und einer Lötverbindung 36 zu der Schaltungsstruktur 29 auf ihrer Frontseite 34 ausgestattet sein, während ihre Rückseiten 17 mit einer metallischen Rückseitenelektrode 37 auf einer metallischen Beschichtung 24 der Aussparung 21 bzw. 22 fixiert sind. Die metallischen Beschichtungen 24 der Aussparungen 21 und 22 stehen mit der Schaltungsstruktur 29 auf der Oberseite 16 des elektrooptischen Steuer- oder Regelgeräts elektrisch in Kontakt.

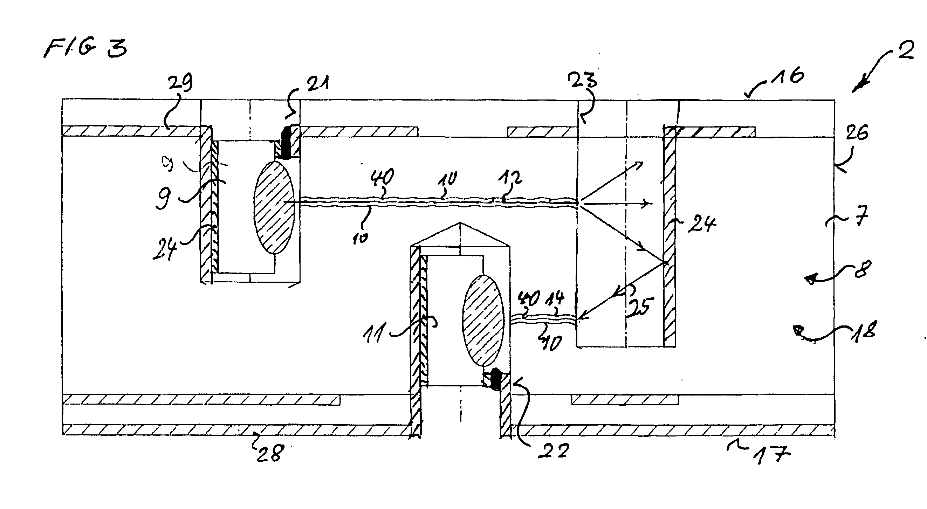

Figur 3 zeigt einen schematischen Querschnitt durch eine optische Übertragungsstrecke 40 in einer Schaltungsplatine 7 gemäß eines erfindungsgemäßen elektrooptischen Steuer- oder Regelgeräts 2. In dieser Übertragungsstrecke 40 ist zwischen der Strahlungsquelle 9 und dem Detektor 11 ein Strahlungsreflektor in einer Aussparung 23 vorgesehen, der von der metallischen Beschichtung 24 gebildet wird. Die über eine obere Glasfaserverstärkungslage 12 übertragenen Lichtsignale werden an der metallischen Beschichtung 24 in der Aussparung 23 reflektiert, wobei der reflektierte Strahl 25 in eine tiefere Glasfaserverstärkungslage 14 der Schaltungsplatine 7 eingespeist wird und in einer auf der Unterseite 17 der Schaltungsplatine 7 angeordneten Aussparung 22 von einem optischen Detektor 11 empfangen und der Metallschicht 28 auf der Unterseite der Schaltungsplatine 17 zugeführt wird. Somit ist es mit dieser optischen Übertragungsstrecke 40 möglich, Halbleiterbauelemente auf der Oberseite 16 mit Halbleiterbauelementen auf der Unterseite 17 über die optische Übertragungsstrecke 40 miteinander zu verbinden.

## Patentansprüche

1. Elektrooptisches Steuer- oder Regelgerät (1) mit einer Steuereinheit (6) wobei:
- die Steuereinheit (6) auf mindestens einer Schaltungsplatine (7), die eine obere Glasfaserverstärkungslage (12) und eine tiefere Glasfaserverstärkungslage (14) aufweist, angeordnet ist, und
- Daten der Steuereinheit (6) optisch von einer Strahlungsquelle (9) über die obere Glasfaserverstärkungslage (12) und die tiefere Glasfaserverstärkungslage (14) als optischem Übertragungsmittel (10) zu einem Detektor (11) übertragen werden,
**dadurch gekennzeichnet, dass**
eine Aussparung (23) in der Schaltungsplatine (7) eine einseitige metallische Beschichtung (24) aufweist, welche die über die obere Glasfaserverstärkungslage (12) übertragene Strahlung der Strahlungsquelle (9) reflektiert, und
eine auf der Unterseite (17) der Schaltungsplatine (7) angeordnete Aussparung (22) einen optischen Detektor (11) aufweist,
wobei der reflektierte Strahl (25) in die tiefere Glasfaserverstärkungslage (14) der Schaltungsplatine (7) eingespeist wird und von dem Detektor (11) empfangen wird.

2. Steuer- oder Regelgerät nach Anspruch 1,
**dadurch gekennzeichnet, dass** die mindestens eine Glasfaserverstärkungslage (12 bis 15) ein Glasfasergewebe (18) aufweist, in dem optische Signaldaten in alle horizontalen Richtungen übertragbar sind und die Gewebekreuzungen optisch Koppelknoten bilden.

## Claims

1. Electro-optical control or regulation device (1) having a control unit (6), wherein:
- the control unit (6) is arranged on at least one circuit board (7), which has an upper glass-fibre reinforced layer (12) and a lower glass-fibre reinforced layer (14), and
- data of the control unit (6) are transmitted optically to a detector (11) by a radiation source (9) via the upper glass-fibre reinforced layer (12) and the lower glass-fibre reinforced layer (14) as optical transmission means (10),
**characterized in that**
a cutout (23) in the circuit board (7) has a one-sided metallic coating (24) which reflects the radiation of the radiation source (9) transmitted via the upper glass-fibre reinforced layer (12), and
a cutout (22) arranged on the underside (17) of the circuit board (7) has an optical detector (11),
the reflected beam (25) being fed into the lower glass-fibre reinforced layer (14) of the circuit board (7) and received by the detector (11).

2. Control or regulation device according to Claim 1, **characterized in that** the at least one glass-fibre reinforced layer (12 to 15) has a glass-fibre fabric (18) in which optical signal data can be transmitted in all horizontal directions, and the fabric intersections form optical coupling nodes.

## Revendications

1. Appareil de commande ou de réglage (1) électro-optique avec une unité de commande (6), dans lequel :
- l'unité de commande (6) est agencée sur au moins une carte de circuit (7) qui présente une couche supérieure de renforcement en fibres de verre (12) et une couche de inférieure de renforcement en fibres de verre (14), et
- les données de l'unité de commande (6) sont transmises de manière optique à un détecteur (11) par une source de rayonnement (9) via la couche supérieure de renforcement en fibres de verre (12) et la couche inférieure de renforcement en fibres de verre (14) en tant que moyen de transmission optique (10),
**caractérisé en ce que**
un évidement (23) dans la carte de circuit (7) présente un revêtement métallique unilatéral (24), qui reflète le rayonnement de la source de rayonnement (9) transmis via la couche supérieure de renforcement en fibres de verre (12), et un évidement (22) agencé sur le côté inférieur (17) de la carte de circuit (7) présente un détecteur optique (11),
dans lequel le faisceau réfléchi (25) est introduit dans la couche inférieure de renforcement en fibres de verre (14) de la carte de circuit (7) et reçu par le détecteur (11).

2. Appareil de commande ou de réglage selon la revendication 1, **caractérisé en ce que** la au moins une couche de renforcement en fibres de verre (12 à 15) présente une toile de fibres de verre (18) dans laquelle des données de signaux peuvent être transmises dans toutes les directions horizontales et les points de croisement de la toile forment des noeuds de couplage optique.
